# EUROPEAN PATENT APPLICATION

(11) **EP 4 838 555 A1**
(43) Date of publication of application: **11.11.2026**
(21) Application number: 25174922.2
(22) Date of filing: 07.05.2025
(51) Int. Cl.: H01J 37/32, H01J 37/34

(54) **LAYER DEPOSITION APPARATUS AND METHOD**

(71) Applicant: Evatec AG, 9477 Trübbach (CH)
(72) Inventor: Weichart, Jürgen, 9496 Balzers (LI); Morciano, Riccardo, 8880 Walenstadt (CH); Rhyner, Stefan, 9470 Buchs (CH); Henzen, Demian, 9463 Oberriet (CH); Kratzer, Martin, 6800 Feldkirch (AT)
(74) Representative: Mantel, Berthold Friedrich

(57) **Abstract**

A layer deposition apparatus and a method of depositing a layer on a substrate are disclosed. The method comprises
- providing a target made of a target material,
- sputtering ions from the target material towards the substrate,
- providing a magnetic field that passes through the target,
- rotating the magnetic field,
- determining a rotational position of the magnetic field, and
- accelerating said ions onto the substrate in dependence of the rotational position.

## Description

### TECHNICAL FIELD

Described herein are a layer deposition apparatus and a method of depositing a layer on a substrate. The apparatus and the method relate to the technical field of wafer production and processing. Also described herein are associated parts and methods of use thereof.

### BACKGROUND ART

In wafer production, for example in 3D NAND production, coating typically leads to the superposition of stress which may result in a bowed wafer and subsequent problems during photolithography or electrostatic clamping. Stress compensation layers are typically applied to the wafer by chemical vapor deposition (CVD) or physical vapor deposition (PVD).

Power modulation at the sputter target in static magnetron sputtering with a rotating magnet arrangement has been developed to correct non-axisymmetric non-evenness issues, like a tilt in thickness, a saddle shape, or even higher order patterns (see, e.g., US20090173621A1). In the prior art, the power applied on the sputtering target is modulated harmonically with the rotation angle α of a non-axisymmetric magnet arrangement. The application of power modulation at the target for impacting the wafer bow is applicable due to the Stoney relationship between local substrate bow and intrinsic stress. However, the applied layers typically have to be removed again prior to further processing steps such as photolithography. Prior art methods which involve depositing a bow compensation layer by physical vapor deposition on the backside of the bowed semiconductor substrate (see, e.g., US10896821B2) may require a shadow mask which adds complexity to the system and increases the risk of particle generation.

It may be an object to provide an improved method for compensating deformation, such as non-axisymmetric deformation, in planar objects undergoing coating, such as wafers and microelectronic objects.

### SUMMARY

The above constraints are addressed by a layer deposition apparatus that comprises a substrate support, a sputtering source, a position sensor, an ion accelerator, and a control device as follows. The sputtering source comprises a target made of a target material, a magnet arrangement causing a magnetic field that passes through the target, and a rotational drive configured to rotate the magnet arrangement about a magnet rotational axis. Further, the sputtering source is configured to sputter ions from the target material towards the substrate support. The position sensor is configured to determine a rotational position of the rotational drive and/or the magnet arrangement and to generate a position signal indicative of the rotational position. The ion accelerator is configured to accelerate said ions onto a substrate supported by the substrate support. The control device is configured to receive the position signal from the sensor and to control acceleration of said ions in dependence of the position signal.

The above constraints are further addressed by a method of depositing a layer on a substrate, wherein the method comprises providing a target made of a target material, sputtering ions from the target material towards the substrate, providing a magnetic field that passes through the target, rotating the magnetic field, determining a rotational position of the magnetic field, and accelerating said ions onto the substrate in dependence of the rotational position.

The authors have recognized that the momentum of the ions accelerated onto the substrate has an impact on the intrinsic stress within the substrate and/or the deposited layer. Both the layer deposition apparatus and the method provide for a different acceleration of the ions onto the substrate in different circumferential areas of the substrate, thereby causing different intrinsic stress within the deposited layer in the different circumferential areas of the substrate. In this way, the abovementioned local substrate bow may be compensated for to increase an flatness of the coated substrate.

In a preferred embodiment of the layer deposition apparatus, the target has a rotationally symmetric shape defining a target symmetry axis that is parallel to, or coincides with, the magnet rotational axis. In another preferred embodiment, the substrate support has a rotationally symmetric shape defining a substrate symmetry axis that is parallel to, or coincides with, the magnet rotational axis. A rotationally symmetric shape of the target, the substrate support and/or a substrate may facilitate an even distribution of the accelerated ions on the substrate.

In another preferred embodiment, the layer deposition apparatus further comprises a vacuum enclosure enclosing a vacuum chamber, wherein the substrate support and the target are arranged in the vacuum chamber. In an even more preferred embodiment, anyone of the magnet arrangement, the rotational drive, the position sensor, and the ion accelerator is arranged in the vacuum chamber. Advantageously, the layer deposition apparatus comprises a pump configured to evacuate the vacuum chamber. Depositing the layer on the substrate at a low pressure or vacuum may facilitate a precise control of the acceleration of the ions onto the substrate.

In preferred embodiment, the ion accelerator comprises an electric-potential generator configured to provide a substrate supported by the substrate support with an electric potential that attracts said ions. By varying the electric potential provided by the electric-potential generator to said substrate, the control device may control acceleration of said ions in dependence of the position signal.

In another preferred embodiment, the ion accelerator comprises a plasma generator configured to provide a plasma in an area between the target and the substrate support. In an even more preferred embodiment, the plasma generator comprises a plasma anode, a plasma cathode, and a sputter-source power supply configured to provide the plasma anode and the plasma cathode with a voltage relative to one another. Advantageously, the cathode comprises the target. The plasma may facilitate generation of the ions and their acceleration onto the substrate.

In another preferred embodiment, the electric-potential generator comprises an RF electrode and an RF-voltage generator configured to provide the RF electrode with an RF voltage at an RF-voltage frequency. Advantageously, an RF frequency of the RF voltage is at least 1 MHz, or at most 30 MHz. In a preferred embodiment, the RF frequency of the RF voltage is 13.56 MHz.

In another preferred embodiment, the RF electrode comprises at least one of the substrate support and a substrate supported by the substrate support. In another preferred embodiment, the layer deposition apparatus further comprises a matching network configured to match an impedance between the RF-voltage generator and the RF electrode. Applying an RF voltage to the substrate support or the substrate may facilitate providing an electric potential to the substrate that attracts the ions.

In another preferred embodiment, the control device varies the electric potential provided by the electric-potential generator to said substrate by varying an amplitude A_{RF} of the RF voltage according to A_{RF}(α) = A₀ + A_{Mod} * f_{Mod}(α_{offset} + n * α), wherein α is an angle of the rotational position, A₀ is a base level amplitude, A_{Mod} is a modulation amplitude, f_{Mod} is a modulation function, α_{offset} is an offset angle, and n is an order number of the modulation function. In some embodiments, n = 1. In an alternative embodiment, n = 2. In further embodiments, n > 2. In a preferred embodiment, the modulation function is a periodic function. In even more preferred embodiments, the modulation function is any one of a trigonometric function, a cosine function, a triangular function, a rectangular function or a combination thereof. Modulating the amplitude of the RF voltage and thus the electric potential in dependence of the angle of the rotational position may facilitate providing the same acceleration of the ions and thus causing the same intrinsic stress in a specific area of the substrate or the deposited layer during any of several subsequent rotations of the magnet arrangement and the magnetic field.

In a preferred embodiment, the ion accelerator comprises a further magnet arrangement causing a magnetic field that passes through the substrate support. In another preferred embodiment, the target material comprises a dielectric material. In another preferred embodiment, the rotational drive is configured to rotate the magnet arrangement at a rotational speed of at least 0.1 RPS (rounds per second), or at most 5 RPS.

In another preferred embodiment, the magnet arrangement comprises a permanent magnet. In an even more preferred embodiment, the magnet arrangement comprises a plurality of permanent magnets. Advantageously, the plurality of magnets is arranged in one or more loops, wherein at least one of the one or more loops surrounds the target symmetry axis. The magnets forming a loop may be oriented in parallel to each other, with their magnetic north poles facing towards the substrate support for a first loop and away from the substrate support for a second loop that surrounds the first loop in a plane perpendicular to the target symmetry axis.

In another preferred embodiment, the layer deposition apparatus further comprises a sputtering-source power supply configured to supply a DC power, or a DC pulsed power to the sputtering source. In another preferred embodiment, the layer deposition apparatus further comprises a sputtering-source power supply configured to supply an RF power at a sputtering-source RF frequency to the sputtering source. Advantageously, the sputtering-source RF frequency is equal to the RF-voltage frequency. Further advantageously, the RF power of the sputtering source is phase-locked to the RF voltage of the RF voltage generator.

In another preferred embodiment, the sputtering source comprises a magnetron sputtering source. In an even more preferred embodiment, the magnetron sputtering source is an unbalanced magnetron sputtering source. Advantageously, the unbalanced magnetron sputtering source is a type-1 unbalanced magnetron sputtering source or a type-2 unbalanced magnetron sputtering source. In a type-1 unbalanced magnetron, a central magnet pole is strengthened relative to an outer magnet pole. In this case, the field lines which do not close in on themselves are directed towards the chamber walls. In a type-2 unbalanced magnetron, the outer magnet pole is strengthened relative to the central magnet pole. In this case, not all the field lines are closed between the central and outer poles in the magnetron, but some are directed towards the substrate, and some secondary electrons are able to follow these field lines.

In another preferred embodiment, the magnetron sputtering source is configured to form one or more plasma confinement lines on a surface of the target facing the substrate support. A plasma confinement line is considered to be a border line between first and second areas of the surface of the target, wherein the magnetic field lines are oriented outwards out of the target in the first area and inwards into the target in the second area. At the plasma confinement line, a component of the magnetic field lines parallel to the target symmetry axis is zero. Advantageously, at least one of the one or more plasma confinement lines is a closed loop that is constrained within two quarters, or one and a half quarter, of the surface of the target. Confining the plasma to a section of the surface of the target in a circumferential direction may facilitate a precise control of the acceleration of the ions in dependence of the rotational position of the magnet arrangement and thus the plasma.

In a preferred embodiment, the method comprises providing the substrate support with an electric potential that attracts said ions. Advantageously, the method comprises controlling acceleration of said ions by varying the electric potential. In an even more preferred embodiment, varying the electric potential provided to said substrate comprises varying an amplitude A_{RF} of the RF voltage according to A_{RF}(α) = A₀ + A_{Mod} * f_{Mod}(α_{offset} + n * α), wherein α is an angle of the rotational position, A₀ is a base level amplitude, A_{Mod} is a modulation amplitude, f_{Mod} is a modulation function, α_{offset} is an offset angle, and n is an order number of the modulation function. In some embodiments, n = 1. In an alternative embodiment, n = 2. In further embodiments, n > 2. In a preferred embodiment, the modulation function is a periodic function. In even more preferred embodiments, the modulation function is any one of a trigonometric function, a cosine function, a triangular function, a rectangular function or a combination thereof. In an alternative embodiment, the modulation function is a rectangular function.

In a preferred embodiment, the method comprises evacuating a space between the target and the substrate. In another preferred embodiment, the method comprises providing a plasma in an area between the target and the substrate support. In another preferred embodiment, the method comprises providing a further magnetic field that passes through the substrate support. In another preferred embodiment, the target material comprises a dielectric material. In another preferred embodiment, the magnet arrangement is rotated at a rotational speed of at least 0.1 RPS, or at most 3 RPS, or at most 5 RPS.

### BRIEF DESCRIPTION OF THE DRAWINGS

Further aspects and advantages of the fastening tool, associated parts and a method of use thereofwill become apparent from the ensuing description that is given by way of example only and with reference to the accompanying drawings in which:
- Fig. 1: illustrates a layer deposition apparatus,
- Fig. 2: illustrates a method of depositing a layer on a substrate,
- Fig. 3: illustrates a shape of a wafer,
- Fig. 4: illustrates a correlation between a stress and an RF bias power,
- Fig. 5: illustrates in part a layer deposition apparatus,
- Fig. 6: illustrates a correlation between a thickness and an RF bias power,
- Fig. 7: illustrates a target and a magnet arrangement,
- Fig. 8: illustrates a block diagram of a synchronisation and RF voltage modulation,
- Fig. 9: illustrates a deposition system,
- Fig. 10: illustrates a stress distribution on a wafer, and
- Fig. 11: illustrates another stress distribution on a wafer.

### DETAILED DESCRIPTION

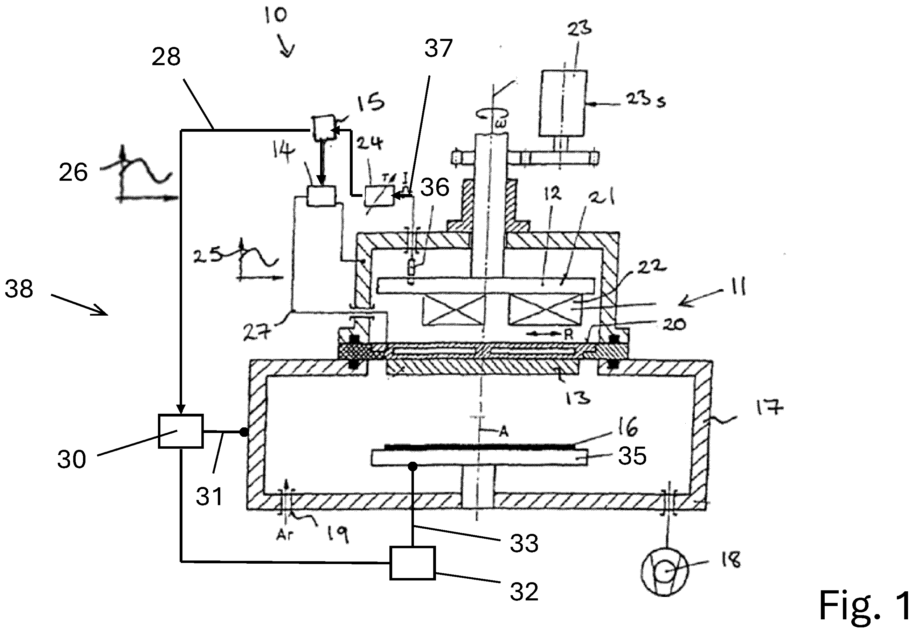

Fig. 1 shows a layer deposition apparatus 10 configured to carry out a method of depositing a layer on a substrate 16 e.g. by chemical vapor deposition (CVD) or physical vapor deposition (PVD). The layer deposition apparatus 10 comprises a sputtering source 11 formed as a magnetron sputtering source, or magnetron, comprising a rotatable magnet arrangement 12 rotatable about a magnet rotational axis A and a target 13 made of a target material such as a dielectric or metallic material. The layer deposition apparatus 10 further comprises a sputter-source power supply 14 configured to produce a periodically modulated electric power with defined amplitudes and phases to the sputtering source 11. The sputter-source power supply 14 is electrically connected to a vacuum enclosure 17 as a plasma anode and the target 13 as a plasma cathode, to provide the plasma anode and the plasma cathode with a voltage relative to one another and thereby generate a plasma in an area between the target 13 and a substrate support 35 configured to support a substrate 16. The sputtering source 11 may be formed as a type-1 or type-2 unbalanced magnetron sputtering source, e.g. including a further magnet arrangement causing a magnetic field that passes through the substrate support 35.

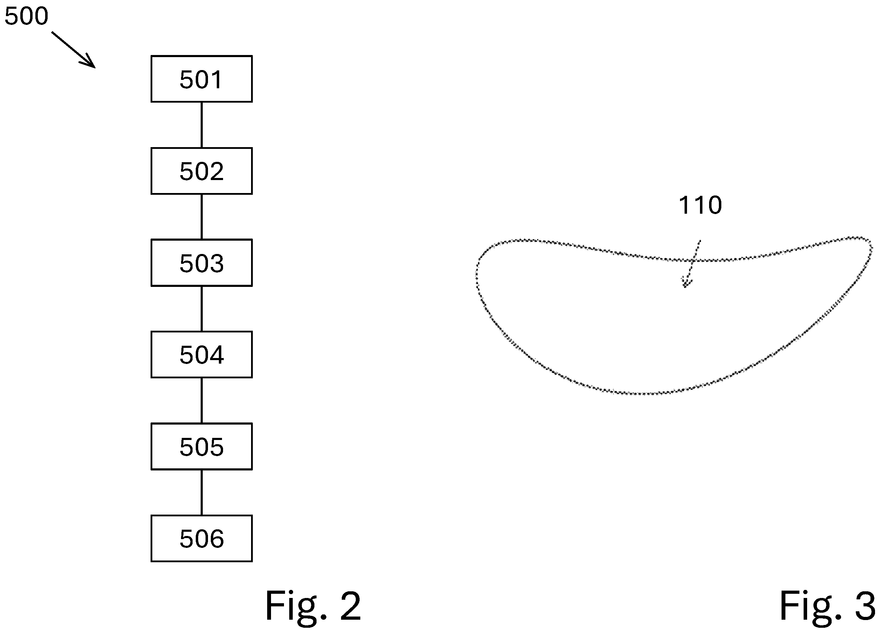

The layer deposition apparatus 10 further comprises a control device 15 such as a synchronization tool that enables the phase synchronization of the periodic power modulation with the magnet rotation. The target 13 has a circular shape defining a target symmetry axis that coincides with the magnet rotational axis A. The sputtering source 11 is configured to sputter ions from the target material of the target 13 towards the substrate support 35. To this end, the target 13 and substrate 16 onto which a film of material of the target 13 is to be deposited are arranged in a vacuum chamber inside the vacuum enclosure 17 facing one another. In the arrangement of Fig. 1, the substrate is positioned on a substrate support 35 at a base of the vacuum enclosure 17 and the target 13 is positioned above the substrate support 35. The substrate support 35 has a circular shape defining a substrate symmetry axis that coincides with the magnet roational axis A. The magnet arrangement 12 causes a magnetic field that passes through the target 13 to enhance sputtering. Both the target 13 and substrate 16 remain stationary during sputtering in the embodiment shown in Fig. 3. The vacuum chamber in the vacuum enclosure 17 may be evacuated by a pump 18 and also includes a gas line 19 for a working gas, preferably argon. A reactive gas for reactive magnetron sputter coating may also be introduced into the vacuum chamber within the vacuum enclosure 17.

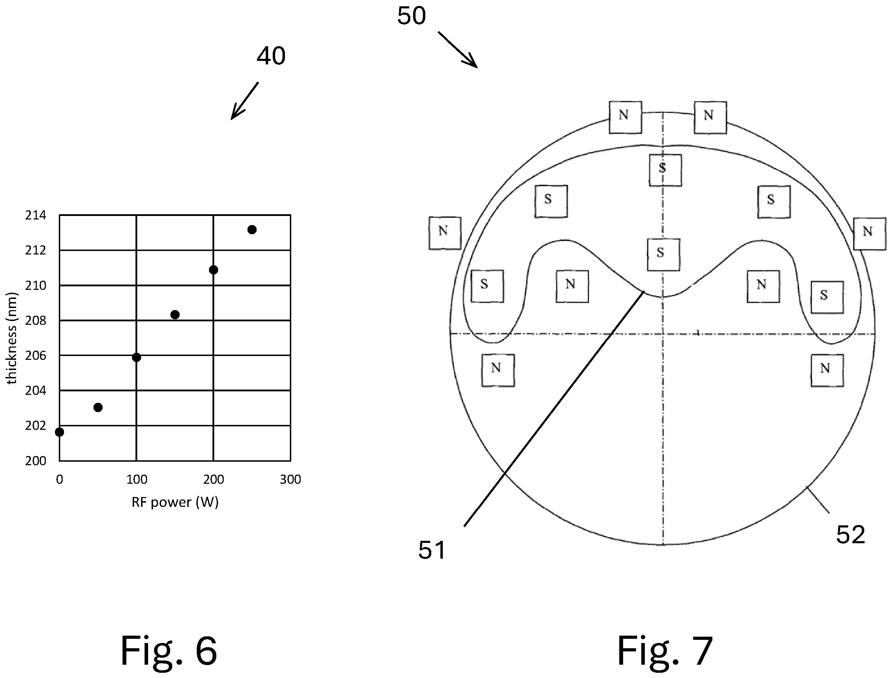

The rotatable magnet arrangement 12 is positioned outside of the vacuum chamber and behind a target back plate 20 on which the target 13 is positioned. The axis of rotation A of the magnet is concentric with a center of the target 13 and a center of the substrate 16, or substrate support 35. The rotatable magnet arrangement 12 includes a rotationally movable magnet carrier plate 21, driven about the magnet rotational axis A, with a configuration of permanent magnets 22 disposed asymmetrically with respect to the magnet rotational axis A and for example kidney-shaped in top view as shown in Fig. 7. The magnets 22 of the magnet arrangement 12 are rotated, as indicated at R, at an angular frequency ω, around the magnet rotational axis A. A rotational position of the magnet arrangement 12 during its rotation as generated by a rotational drive 23 having a motor with control input 23s is determined, or scanned, by means of a position sensor 36. In an alternative embodiment, a rotational position of the rotational drive 23, e.g. its motor, is determined by the position sensor. The position sensor 36 generates a position signal I that indicates, or represents, the determined rotational position. The position signal I is submitted via a signal line 37 and a signal processor 24 to the control device 15. The signal processor 24 may e.g. add a time delay to the position signal I. The control device 15 receives the position signal I from the position sensor 36 via the signal processor 24 and controls modulation of electric power supplied to the sputtering source 11 by the sputter-source power supply 14 and acceleration of the ions sputtered by the sputtering source 11 onto the substrate 16 by an ion accelerator 38 as described below in dependence of the position signal I. In alternative embodiments, the magnet arrangement, the rotational drive, the position sensor and/or the ion accelerator may be arranged in the vacuum chamber.

The ion accelerator 38 comprises an electric-potential generator that provides the substrate 16 with an electric potential that attracts the ions sputtered by the sputtering source 11. To this end, the electric-potential generator comprises the substrate support 35 and/or the substrate 16 as an RF electrode, the vacuum enclosure 17 as an RF counter electrode, an RF-voltage generator 30 that provides the RF electrode with an RF voltage at an RF-voltage frequency of 13.56 MHz, and a matching network 32 that matches an impedance between the RF-voltage generator 30 and the RF electrode. The RF-voltage generator 30 is connected to the vacuum enclosure 17 via a first electric cable 31, and the matching network is connected to the substrate support 35 via a second electric cable. In this way, an RF self-bias voltage is generated at the substrate 16 to form the electric potential that attracts the ions. The control device 15 controls modulation of the RF voltage provided to the RF electrode by the RF-voltage generator 30 in dependence of the position signal I and thereby in dependence of the rotational position of the magnet arrangement.

Fig. 2 illustrates a method 500 of depositing a layer on a substrate. In a first step 501, a target made of a target material is provided. In a subsequent step 502, a space between the target and the substrate is evacuated. In a subsequent step 503, a plasma in an area between the target and the substrate support is provided to sputter ions from the target material towards the substrate. In a subsequent step 504, a magnetic field that passes through the target is rotated about a magnet rotational axis at a rotational speed of at least 0.1 RPS and/or at a rotational speed of at most 5 RPS. In a subsequent step 505, a rotational position of the magnetic field is determined. In a subsequent step 506, the substrate support is provided with an electric potential that attracts said ions, and acceleration of said ions is controlled by varying the electric potential to accelerate the ions onto the substrate in dependence of the rotational position.

The substrate, or wafer, for use in the present method may be a wafer used in the microelectronic and semiconductor industry, for example a silicon wafer, e.g. as used for the 3D-NAND technology. The wafer for use in the present method may be coated with different materials used in typical semiconductor applications, or it may be a non-coated wafer, e.g. silicon wafer. As used herein, the term "bowed wafer" means that the wafer is deformed out of a plane. Herein, the term "bowed" is, for easier reading, used to refer to any shape of wafer deformations which may be characterized by bowing and/or warping. In a symmetrically bow-shaped wafer, the bow is the deviation of the center point of the median surface of a free, un-clamped wafer from the reference plane. In a symmetrically wave-shaped wafer, the bow is characterized by a deflection value which is the difference between the maximum and the minimum distances of the median surface of a free, un-clamped wafer from the reference plane. Wafers may also be bowed in higher orders, e.g. in the form of a saddle which will feature different deflection values along two orthogonal axes: two opposing edges of the wafer are curved upward, and two opposing edges are curved downward. Typical shapes of deformed wafers, i.e. "bowed wafers" used herein, include the aforementioned saddle shape and a "potato chip" shape. Fig. 3 shows a wafer 110 having a saddle shape shown in a superelevated representation.

Mitigating bowing of a substrate by static magnetron sputtering with a rotating magnet arrangement may be described in the following scheme (Scheme I):
i) Providing at least one bowed wafer,
ii) measuring a bow in a geometry of the wafer,
iii) determining a position of at least one bow maximum relative to an alignment of the wafer in a magnetron sputtering device,
iv) mitigating bowing by sputtering a dielectric layer on the wafer while modulating an RF bias power as a function of a magnet arrangement rotation angle, the position and the amplitude of the bow maximum,
v) optionally determining if bow mitigation was sufficient, and
vi) optionally repeating step (iv) with one or more further wafers of essentially the same geometry to tune modulation of the RF bias power.

In the context of all aspects and embodiments disclosed herein, the term "RF power", or "RF bias power", refers to an RF signal with a frequency in the range of 2 to 41 MHz, preferably in the range of 5 to 20 MHz, more preferably of 13.56 MHz. The modulation of RF bias power is performed as a function of the magnet arrangement rotation angle, the position of at least one bow maximum and the amplitude of the at least one bow maximum. For the example of a pulsed DC sputtering method, the modulation of RF bias power is a modulation of the amplitude of the RF bias power (A_{Mod}), e.g. around a predetermined RF bias power level (A₀).

In step (i) of Scheme I, a bowed wafer as explained above is provided. For example, a batch of wafers produced under the same conditions and featuring essentially the same material composition and geometry (bowing) may be provided, of which a first bowed wafer is taken for step (II) of the present method.

In step (ii) of Scheme I, the bow in the geometry of the wafer is determined by measurement. The geometry refers to the 3D-shape of the wafer. In step (ii), the bow in the geometry is determined at least to the extent that the number of deflection maxima and the position of at least one bow maximum of the wafer are detected. In an example, the number of bow maxima, the amplitude of bowing and the position of one or more maxima are determined. The amplitude of bowing refers to the extent of deviation of a bow maximum from the plane of the wafer. In other words, in an example, the 3D-geometry of the entire wafer is determined as a wafer map. Suitable means for the determination of bow (i.e. for wafer mapping) in step (ii) are known in the art and include, e.g., optical means (e.g. based on laser measurements) and mechanical means (e.g. using a mechanical needle on the wafer providing capacitive (or inductive) feedback). While an in situ measurement of bow (i.e. for wafer mapping) in step (ii) in the magnetron sputtering device, or in a chamber associated with the layer deposition apparatus (e.g. a load lock) is included in the scope of the present invention, the measurement may also be performed in-line or outside the device, e.g. under environmental conditions which mimic those of future applications of the wafer.

In preparation for step (iv) of Scheme I, the position of the at least one bow maximum (as determined in step (ii)) is determined in step (iii) relative to the alignment of the wafer in a magnetron sputtering device used for step (iv). The position of the at least one maximum may be determined as the offset angle α_{offset}. In other words, the orientation of the at least one maximum of the wafer bow is determined as an offset angle with respect to the alignment of the wafer in the magnetron sputtering device. The position of the at least one maximum in the magnetron sputtering device is used for aligning the position of the magnet arrangement (and thereby the magnetron) with the at least one maximum of the wafer during modulation of an RF bias power in step (iv). The amplitude of the at least one and optionally further maxima may also have been determined in step (ii) or, alternatively, in step (C) of the calibration method described further below.

In step (iv) of Scheme I, the bowing of the wafer is mitigated by sputtering a dielectric layer on the wafer while modulating an RF bias power applied to the wafer as a substrate. The term "mitigate bowing" as used herein means that the wafer is essentially "flattened", e.g. to a degree which is sufficient for further handling (e.g. lithography or electrostatic chuck transportation). Preferably, a bow is mitigated to a maximum non-uniformity of +/- 10 µm. The method is carried out in a sputtering device in which the substrate and target are static while the magnet arrangement rotates and is non-axisymmetric relative to the magnet rotational axis. For simplicity, the term "magnet arrangement" is used when referring to the combination of (permanent) rotatable magnets used for the magnetron. A magnetron typically comprises multiple magnets for generating a magnetic field which confines a plasma. Any number of magnets is encompassed in the present invention that is suitable for magnetron sputtering purposes in a non-axisymmetric configuration with respect to the magnet rotational axis. The skilled person understands that the location of the magnet arrangement defines the position of the magnetron.

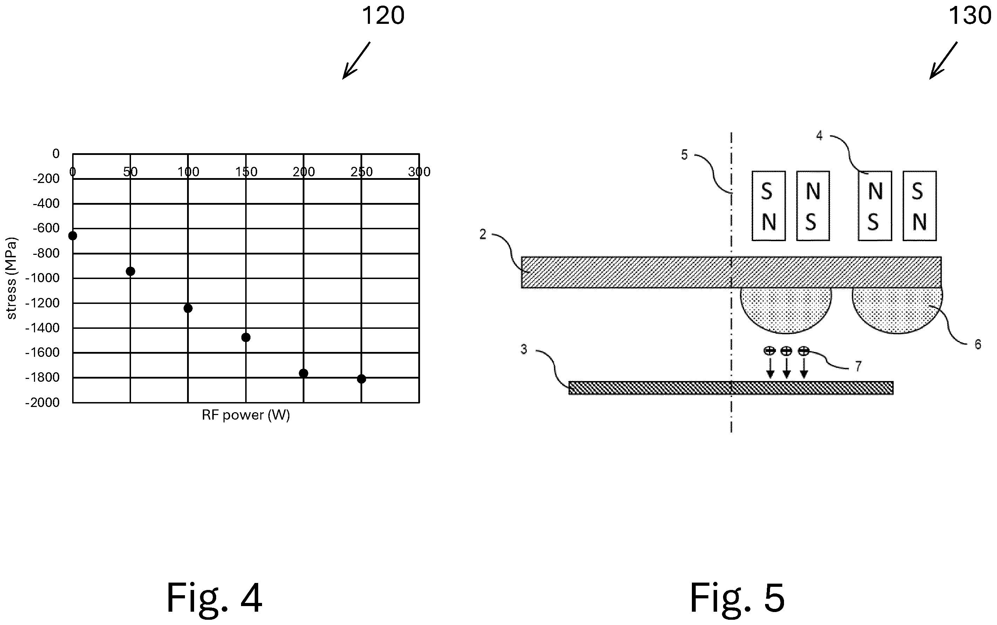

The dielectric layer is, for example, deposited on the backside of the wafer, i.e. the non-coated side of a pre-coated wafer. Alternatively, it may be deposited on the coated side (front side) of the wafer. The term "metallic" as used herein includes metalloids such as silicon. The metallic layer is deposited from a metallic target such as, e.g., a Si, Al or Ti target by pulsed DC or RF sputtering under a noble gas atmosphere (e.g. under an Ar, Kr or Ne atmosphere) or by reactive pulsed DC or RF sputtering under an atmosphere including a reactive gas such as N₂ or O₂. Exemplary pulsed DC sputter powers for the target (cathode) include about 11 to 14 kW for a target of about 400 mm diameter, e.g. a Si target. Exemplary layers include SiN and AIN layers. Depending on the choice of the layer, said layer will impart a compressive or tensile stress on the wafer. For example, a SiN layer exerts a compressive stress, whereas an AIN layer exerts a tensile stress. Hence, the choice of the layer also, in simple terms, determines the primary direction in which the wafer is deformed, e.g. "flattened". The stress of the resulting layer which is deposited is adjusted by the RF bias power applied to the substrate in order to mitigate the bow. Fig. 4 shows an exemplary correlation 120 between stress in a SiN-layer and RF bias power on the substrate.

For this purpose, a non-axisymmetric rotating magnet arrangement located behind the target may be used in the described apparatus and/or method. The RF bias power applied to the substrate is modulated such that, in simplified and explanatory terms, when the plasma confinement region as defined by the extension of the non-axisymmetric rotating magnet arrangement reaches the bow maximum, plasma ions (e.g. Ar⁺ ions) are accelerated out of the confinement region (aligned with the bow maximum) towards the substrate shifting or increasing the local stress of the growing sputter layer on the substrate from tensile to compressive or from compressive to more compressive.

Fig. 5 shows in part a layer deposition apparatus 130 comprising a non-axisymmetric (around magnet rotational axis 5) rotating magnet arrangement 4 behind a target 2. The rotating magnet arrangement 4 allocates and accelerates plasma ions 7 (e.g. Ar⁺ ions) out of a confined plasma 6 towards a substrate 3. This shift to (more) compressive local stress mitigates the bowing in the wafer.

According to the described method, the stress alteration by RF bias modulation essentially does not affect the thickness. Fig. 6 shows an exemplary correlation 40 between thickness of a deposited SiN-layer and RF bias power on the substrate. The thickness of the SiN-layer only marginally increases (from about 202 nm to about 213 nm) upon an increase of RF bias power (from 0 to 250 W). A limited amount (e.g. maximum 10%) of etching caused by the ions accelerated towards the substrate may occur but essentially does not impact the bow mitigation. Also, no moving parts are required in the vacuum chamber of a magnetron sputtering device suitable for carrying out the described method. Generally, the more eccentric the magnet rotational axis and the smaller the magnet arrangement defining the plasma confinement region is, the more effective the local stress control may be applied. The magnet arrangement for use in the present invention should be designed to provide even deposition on the substrate.

Fig. 7 shows a top view of an exemplary non-axisymmetric rotatable magnet arrangement 50. A magnetic field induced by the magnet arrangement 50 is represented by its magnetic north poles N and magnetic south poles S. A racetrack line 51 on a surface of a circular target 52 forms between opposite magnetic poles and is confined between two plasma confinement lines as defined further above. The racetrack line 51 and the plasma confinement lines each form a closed loop and are constrained in about one half-circle of the target 52. In other embodiments, the confinement of a racetrack line has, for example, a kidney shape, a heart shape, or an "Omega" shape. In some embodiments, the racetrack line is confined to two quarters, or one and a half quarter, of the surface of the target.

The predetermined RF bias power level may be known from experience or may be determined or at least approximated by conducting calibration according to Scheme II described further below. This calibration of the baselevel RF bias power is carried out on a wafer of essentially the same geometry (e.g. from the same production batch) as described above. The extent of bowing will be factored into the determination of the predetermined RF bias power level (A₀).

The power value (amplitude) of the RF bias power (A_{Mod}) that is modulated, e.g. around a predetermined RF bias power level (A₀), may be chosen based on experience or based on iterative repetition of steps i) to vi) of Scheme I for mitigating bowing in a wafer by static magnetron sputtering with a rotating magnet. As an example, the modulation of RF bias power A_{RF} during step (iv) of Scheme I may be performed according to the formula A_{RF}(α) = A₀ + A_{Mod} * f_{Mod}(α_{offset} + n * α), wherein α is the rotation angle of the magnet, f_{Mod} is a modulation function, e.g. a periodic function such as a trigonometric function, a cosine function, a triangular function or a rectangular function, α_{offset} defines the orientation of the at least one bow maximum with respect to the alignment of the wafer, n is the number of bow maxima on the wafer (e.g. 1 for a tilt or 2 for a saddle and a potato chip), and A₀ and A_{Mod} are as defined above.

In a further embodiment, the sputter power is an RF sputter power (instead of pulsed DC). In this case, the RF bias power phase may be aligned relative to the phase of the RF sputter power (e.g. one frequency defined as a harmonic of the other), e.g. phase-locked with the RF sputter power. Another embodiment comprises a non-axisymmetric rotating magnet arrangement, wherein the offset of the magnet arrangement from the magnet rotational axis may be varied, e.g. as a function of the radial location of the at least one bow maximum on the wafer relative to the magnet rotational axis. Thereby, a two-dimensional description of the position of the at least one bow maximum may be used (angle of magnet arrangement rotation and distance from a center of the wafer and/or from the magnet rotational axis) to modulate the RF bias power during step (iv). Typically, a processing time of step (iv) is in the range of 50 to 300 sec and a typical film thickness of the deposited film is in the range of 100 to 500 nm.

After step (iv), the wafer geometry may be again measured in step (v) to assess whether the bow was sufficiently mitigated (e.g. to the extent described above). Suitable methods are known and include those explained in the context of step (ii). If the mitigation of the bow was not sufficient, step (iv) may be repeated on a further wafer of essentially the same geometry (e.g. from the same batch) under the same or different process conditions, e.g. with different modulation of the RF bias power, wherein, e.g. A_{Mod}, the offset angle α_{offset} and/or processing times are adapted.

In an embodiment, the present method further comprises a method of calibration of baselevel RF bias power (A₀) to mitigate bowing by magnetron sputtering. The calibration method essentially serves to determine the RF bias power (A₀) which may be applied in the method of mitigating bowing by magnetron sputtering after calibration. Calibration of baselevel RF bias power to mitigate bowing by magnetron sputtering may be described in the following scheme (Scheme II):
A) Providing at least one bowed wafer,
B) measuring a bow in a geometry of the wafer,
C) mitigating bowing of the wafer to a baselevel by sputtering a dielectric layer on the wafer with a predetermined RF bias power (A₀),
D) verification if baselevel is reached, and
E) optionally repeating steps (C) and (D) with one or more further wafers of essentially the same geometry to tune A₀ to reach the baselevel.

In step (A) of Scheme II, a bowed wafer is provided as explained above in the context of step (i). This wafer is a wafer of essentially the same geometry (e.g. from the same batch) compared to a further wafer that will be subjected to the method of mitigating the bow after calibration. Step (B) is carried out essentially in analogy to step (ii) of the method of mitigating the bow and this information may be used in lieu of carrying out step (ii). In step (C), the bowing of the wafer is mitigated by sputtering a metal nitride layer on the wafer with a non-modulated RF bias power (A₀) applied to the wafer as a substrate. "Non-modulated", as used herein, means that a predetermined power is applied without changing the amplitude and/or offset of the RF bias power.

The metallic layer for use in the calibration method is of the same chemical composition, i.e. sputtered from a target of the same chemical composition and under the same atmosphere that is used in the method to mitigate bowing by static magnetron sputtering with a rotating magnet arrangement. The layer is, for example, deposited on the backside of the wafer, i.e. the non-coated side of a pre-coated wafer, or on the front (coated) side. The layer will be deposited on the same side compared to step (iv) of Scheme I, yet on a further wafer. As described for step (iv) of Scheme I, the layer may be compressive or tensile, depending on the desired direction of wafer deformation.

Advantageously, method step (C) is carried out in a sputtering device as described in step (iv) of Scheme I. As noted above, sputtering is performed under the same conditions (except for the modulation of the RF bias power) as it will be performed after calibration in step (iv) of Scheme I by pulsed DC or RF under a noble gas atmosphere (e.g. under an Ar, Kr or Ne atmosphere) or by reactive pulsed DC or RF sputtering under an atmosphere including a reactive gas such as N₂ or O₂. Exemplary pulsed DC sputter powers are those noted for the subsequent step (iv) of Scheme I and include about 11 to 14 kW for a target of about 400 mm diameter, e.g. a Si target. If an RF sputter power (instead of pulsed DC) is used, the non-modulated RF bias power phase may be phase-locked with the RF sputter power. Deposition times may differ from step (iv) of Scheme I and be in the range of 50 to 300 sec, while typical film thicknesses of the deposited film are in the range of 100 to 500 nm, which may again differ from those in step (iv) of Scheme I.

After step (C), the bow of the wafer is measured as described for step (B) and step (D) of verifying if a baselevel is reached, i.e. if the wafer bow is mitigated to a degree which allows for the RF bias power (A₀) to be applied in step (iv) of Scheme I. The baselevel may be determined by the skilled person in the art to be a sufficiently bow-compensated wafer. The degree of bow mitigation that is considered the baselevel may vary, e.g. depending on the geometry of the wafer (including the number n), the amplitude of the bow maximum/maxima and the thickness of the deposited film during the process. Essentially, the baselevel is a level of bow mitigation resulting from a non-modulated RF bias power level around which the modulated RF bias power of step (iv) of Scheme I may be set to achieve mitigation of the bow in the method to mitigate bowing by static magnetron sputtering with a rotating magnet. The baselevel is typically not a completely flat wafer but a wafer that comprises bow maxima with an amplitude that may be mitigated by the modulated RF bias power of step (iv) of Scheme I. If the desired baselevel was not reached in step (C), steps (C) and (D) are repeated with one or more further wafers of essentially the same geometry to tune A₀ to reach the desired baselevel. Tuning A₀ includes setting different power levels (e.g. increasing or decreasing kW numbers).

In an alternative embodiment, the method discussed above for mitigating bowing by static magnetron sputtering with a rotating magnet arrangement is essentially carried out on a flat, i.e. non-bowed, wafer. This method will lead to a bowed wafer (it induces bowing) and may be used as a stand-alone method, as a calibration method or as a proof-of-concept method for the method of mitigating bowing by static magnetron sputtering with a rotating magnet arrangement on a bowed wafer. The RF bias power and/or the determination of the at least one bow maximum on the wafer relative to the alignment of the wafer in a magnetron sputtering device may be inferred from the results of a calibration according to Scheme III below. To this end, calibration of wafer alignment and modulated RF bias power by inducing bowing by magnetron sputtering may be described in the following scheme (Scheme III):
a) Providing at least one flat wafer,
b) inducing bowing by sputtering a dielectric layer on the wafer in a magnetron sputtering device while modulating an RF bias power as a function of a magnet arrangement rotation angle
c) measuring a bow in a geometry of the wafer,
d) determining a position of at least one bow maximum on the wafer relative to the alignment of the wafer in the magnetron sputtering device, and
e) optionally repeating step (b) with one or more further flat wafers to tune modulation of the RF bias power and alignment of bow maximum in the magnetron sputtering device.

In step (a), a wafer as defined above in the context of method steps (i) and (A) is provided with the difference that the wafer is essentially flat, i.e. not bowed. For step (b), this flat wafer is then placed in a magnetron sputtering device as explained above in the context of method step (iv) of Scheme I. The magnetron sputtering device, the target and the gas atmosphere used for step (b) are as defined for step (iv) and sputtering is performed under the same conditions as detailed for step (iv) by pulsed DC or RF under a noble gas atmosphere (e.g. under an Ar, Kr or Ne atmosphere) or by reactive pulsed DC or RF sputtering under an atmosphere including a reactive gas such as N₂ or O₂. Exemplary pulsed DC sputter powers are those noted for step (iv) and include about 11 to 14 kW for a target of about 400 mm diameter, e.g. a Si target. If a RF sputter power (instead of pulsed DC) is used, the non-modulated RF bias power phase may be phase-locked with the RF sputter power.

The RF bias power is modulated as a function of the magnet arrangement rotation angle, which will define the location of the bow maxima resulting from step (b) of Scheme III. In other words, the skilled person deliberately defines the modulation (amplitude and optionally phase) of the RF bias power at specific rotation angles of the magnet arrangement, e.g. to induce n (integer as defined above) bow maxima on the wafer. Sputtering power, the modulation of the RF bias power (power level, amplitude and optionally phase) and the sputtering duration may essentially be set by the skilled person based on experience or based on iterative repetition of steps (a) to (e) of calibrating wafer alignment and modulating RF bias power by inducing bowing of a wafer by magnetron sputtering. After step (b), the bow in wafer geometry is measured in step (c). This measurement is done in analogy to steps (ii) and (B) described above. Specifically, the location of the bow maximum or maxima, and/or the amplitude of the bow is determined, depending on what information the skilled person would like to retrieve. For example, the 3D-geometry of the entire wafer may be determined as a wafer map.

The information gathered in step (c) is subsequently used in step (d) to determine the position of at least one bow maximum on the wafer relative to the alignment of the wafer in the magnetron sputtering device. In other words, the relationship between RF bias modulation and the rotation angle of the magnet arrangement may be determined regarding the location of the bow maximum/maxima. In this way, for example, the offset angle α_{offset} as detailed above may be determined for a given RF bias power modulation. Additionally, the extent of bowing (amplitude) may be determined in step (c) which will provide information on the relationship between RF bias modulation and bow amplitude. The information gained in step (c) and (d) may, for example, be used to determine suitable parameters for method step (iv) of Schemel for a bowed wafer which has the geometry (or at least the bow maximum position and/or amplitude) of the wafer which results from step (b) of Scheme III. Alternatively, the bowed wafer obtained from method step (b) may, in particular after step (d), be flipped around and method step (iv) of Scheme I may be performed on the flipped wafer while the offset angle determined in step (d) is rotated by 90° for carrying out method step (iv) and all other parameters of step (b) are iterated in step (iv). This will result in a mitigation of the previously (step (b)) introduced bow in the wafer. Step (b) may optionally be repeated with one or more further wafers to tune the modulation of the RF bias power and alignment of bow maximum in the magnetron sputtering device. For example, after repeating step (b), steps (c) and (d) are also carried out to determine the results of step (b) as detailed above.

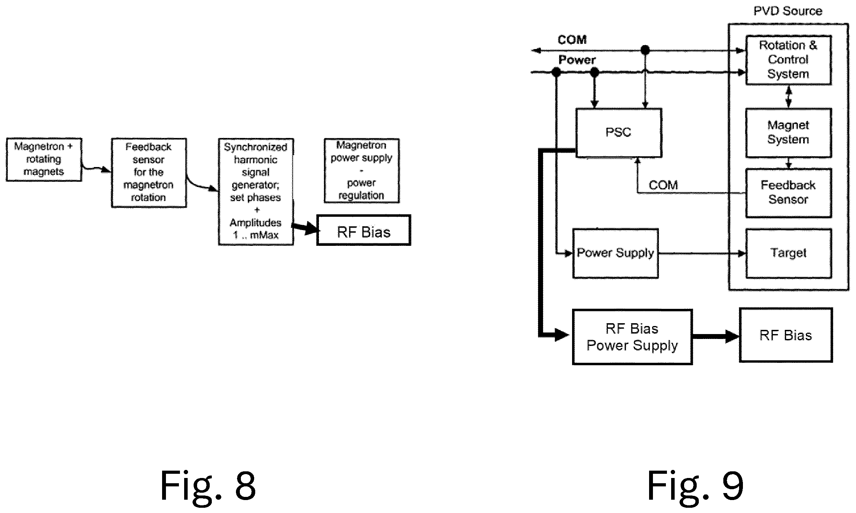

Referring to Fig. 8 and Fig. 9, an embodiment of the method provides a periodic modulation of an RF voltage applied to an RF electrode by an RF-voltage generator during sputtering. In particular, the RF voltage is periodically modulated in time at an RF-voltage frequency. Fig. 8 illustrates a block diagram of a synchronization and RF voltage modulation suitable for use in the embodiment described herein. The embodiment includes a magnetron comprising rotating magnets, a feedback sensor for the magnetron rotation, a synchronized signal generator configured to set the phase and amplitude of the RF voltage, and a sputter-source power supply with power regulation. The sputter-source power supply is configured to supply a DC power or a DC pulsed power to the sputtering source. In a further embodiment, the sputter-source power supply is configured to supply an RF power at a sputtering-source RF frequency to the sputtering source. The sputtering-source RF frequency may be eqal to the RF-voltage frequency of the RF-voltage generator, wherein the RF power of the sputtering source is phase-locked to the RF voltage of the RF voltage generator.

The deposition system is illustrated in more detail in Fig. 9. The deposition system comprises a rotation and control system, a magnet system, a feedback sensor and a target. The deposition system further includes a sputter-source power supply applied to the target and a power supply controller which receives signals from the feedback sensor and the sputter-source power supply and determines the time-dependent frequency and phase of the periodically modulated RF voltage supplied to a substrate holder or substrate, synchronized with the angular rotation of the magnet system. The power supply controller may also control a modulation, for example a sign or cosine wave, of the power supplied to the target.

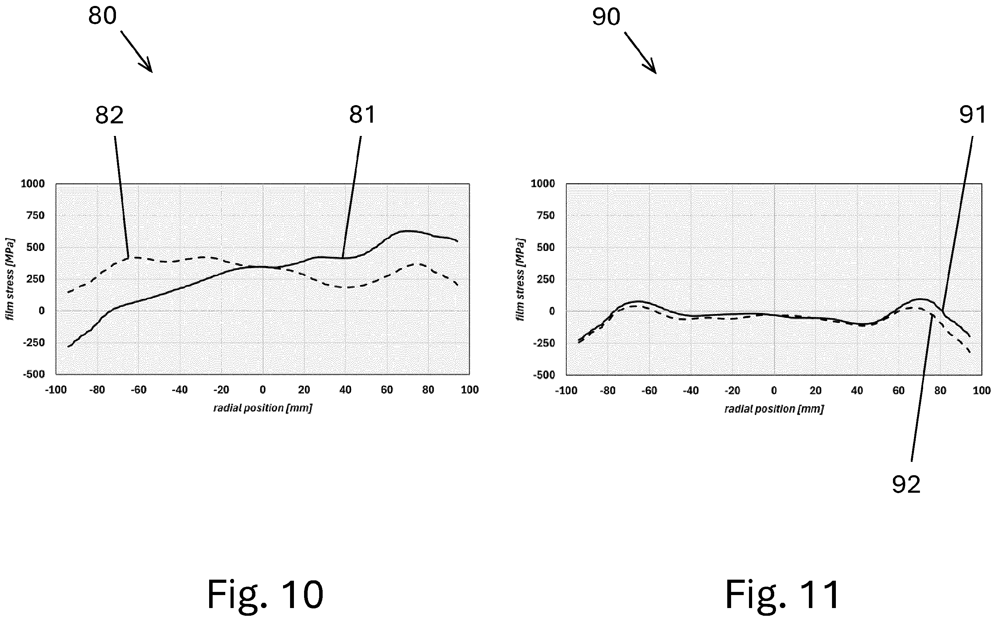

Fig. 10 shows, for a wafer after treatment according to prior known methods, a first stress distribution 81 within a layer on the wafer along a first direction across the wafer and a second stress distribution 82 within the layer on the wafer along a second direction across the wafer. The second direction is perpendicular to the first direction. The first stress distribution 81 along the first direction rises from a stress of -250 MPa at one edge of the wafer to a stress of about 600 MPa at the opposite edge of the wafer. In contrast, the second stress distribution 82 along the second direction varies between about 150 MPa and 400 MPa. From this it follows that the stress on the wafer comprises a tilt in the first direction.

Fig. 11 shows, for a wafer treated according to the method described herein, a first stress distribution 91 within a layer on the wafer along a first direction across the wafer and a second stress distribution 92 within the layer on the wafer along a second direction across the wafer, wherein the second direction is perpendicular to the first direction. Both the first stress distribution 81 and the second stress distribution 82 vary between about -100 MPa and +100 MPa if the edge region of the wafer is not considered. From this it follows that the stress is more evenly distributed on the wafer as compared to the wafer shown in Fig. 10, thus confirming that any tilt has been compensated for by performing the method described herein.

The foregoing description of exemplary embodiments of the invention has been presented for purposes of illustration and of description. It is not intended to be exhaustive or to limit the invention to the precise form disclosed, and modifications and variations are possible in light of the above teachings or may be acquired from practice of the invention. The functionality described may be distributed among modules that differ in number and distribution of functionality from those described herein. Additionally, the order of execution of the functions may be changed depending on the embodiment. The embodiments were chosen and described in order to explain the principles of the invention and as practical applications of the invention to enable one skilled in the art to utilize the invention in various embodiments and with various modifications as suited to the particular use contemplated. It is intended that the scope of the invention be defined by the claims appended hereto and their equivalents. In all methods and schemes described herein, all method steps are optionally performed in numerical and alphabetical order, respectively.

## Claims

1. A layer deposition apparatus
comprising
- a substrate support,
- a sputtering source comprising a target made of a target material, a magnet arrangement causing a magnetic field that passes through the target, and a rotational drive configured to rotate the magnet arrangement about a magnet rotational axis, wherein the sputtering source is configured to sputter ions from the target material towards the substrate support,
- a position sensor configured to determine a rotational position of at least one of the rotational drive and the magnet arrangement and to generate a position signal indicative of the rotational position,
- an ion accelerator configured to accelerate said ions onto a substrate supported by the substrate support,
- a control device configured to receive the position signal from the sensor and to control acceleration of said ions in dependence of the position signal.

2. The layer deposition apparatus according to any one of the preceding claims, wherein the ion accelerator comprises an electric-potential generator configured to provide a substrate supported by the substrate support with an electric potential that attracts said ions, and wherein the control device controls acceleration of said ions by varying the electric potential provided by the electric-potential generator to said substrate.

3. The layer deposition apparatus according to any one of the preceding claims, wherein the ion accelerator comprises a plasma generator configured to provide a plasma in an area between the target and the substrate support.

4. The layer deposition apparatus according to any one of the preceding claims, wherein the electric-potential generator comprises an RF electrode and an RF-voltage generator configured to provide the RF electrode with an RF voltage at an RF-voltage frequency.

5. The layer deposition apparatus according to any one of the preceding claims, wherein the RF electrode comprises at least one of the substrate support and a substrate supported by the substrate support.

6. The layer deposition apparatus according to any one of the preceding claims, wherein the control device varies the electric potential provided by the electric-potential generator to said substrate by varying an amplitude A_{RF} of the RF voltage according to ${A}_{RF} \left(α\right) = {A}_{0} + {A}_{Mod} * {f}_{Mod} \left({α}_{offset}+n*α\right)$ wherein α is an angle of the rotational position, A₀ is a base level amplitude, A_{Mod} is a modulation amplitude, f_{Mod} is a modulation function, α_{offset} is an offset angle, and n is an order number of the modulation function.

7. The layer deposition apparatus according to any one of the preceding claims, further comprising a sputtering-source power supply configured to supply an RF power at a sputtering-source RF frequency to the sputtering source.

8. The layer deposition apparatus according to any one of the preceding claims, wherein the sputtering-source RF frequency is equal to the RF-voltage frequency.

9. The layer deposition apparatus according to any one of the preceding claims, wherein the RF power of the sputtering source is phase-locked to the RF voltage of the RF voltage generator.

10. The layer deposition apparatus according to any one of the preceding claims, wherein the magnetron sputtering source is configured to form one or more plasma confinement lines on a surface of the target facing the substrate support.

11. The layer deposition apparatus according to any one of the preceding claims, wherein at least one of the one or more plasma confinement lines is a closed loop that is constrained within two quarters, or one and a half quarter, of the surface of the target.

12. A method of depositing a layer on a substrate
comprising
- providing a target made of a target material,
- sputtering ions from the target material towards the substrate,
- providing a magnetic field that passes through the target,
- rotating the magnetic field,
- determining a rotational position of the magnetic field,
- accelerating said ions onto the substrate in dependence of the rotational position.

13. The method according to any one of the preceding claims, further comprising providing the substrate support with an electric potential that attracts said ions.

14. The method according to any one of the preceding claims, further comprising controlling acceleration of said ions by varying the electric potential.

15. The method according to any one of the preceding claims, wherein varying the electric potential provided to said substrate comprises varying an amplitude A_{RF} of the RF voltage according to ${A}_{RF} \left(α\right) = {A}_{0} + {A}_{Mod} * {f}_{Mod} \left({α}_{offset}+n*α\right)$ wherein α is an angle of the rotational position, A₀ is a base level amplitude, A_{Mod} is a modulation amplitude, f_{Mod} is a modulation function, α_{offset} is an offset angle, and n is an order number of the modulation function.
